(19) Europäisches Patentamt
European Patent Office
Office européen des brevets

(11) Publication number : **0 363 113 B1**

(12) # EUROPEAN PATENT SPECIFICATION

(45) Date of publication of patent specification :
**09.12.92 Bulletin 92/50**

(51) Int. Cl.⁵ : **G01B 7/02,** B07C 5/12,
**G01B 7/06,** B07C 5/34

(21) Application number : **89310032.1**

(22) Date of filing : **02.10.89**

(54) **Glass container inspection apparatus.**

(30) Priority : **05.10.88 US 253832**
**05.10.88 US 253827**

(43) Date of publication of application :
**11.04.90 Bulletin 90/15**

(45) Publication of the grant of the patent :
**09.12.92 Bulletin 92/50**

(84) Designated Contracting States :
**DE FR GB IT**

(56) References cited :
**DE-A- 2 206 409**
**DE-B- 2 403 243**
**FR-A- 2 435 696**
**GB-A- 2 179 648**
**US-A- 2 616 068**

(73) Proprietor : **Emhart Glass Machinery
Investments Inc.
c/o RL&F Service Corp. One Rodney Square,
10th Floor 10th and King Streets
Wilmington, Delaware 19801 (US)**

(72) Inventor : **Baker, Russ J.
132 Overlook Drive
Horseheads New York 14845 (US)**
Inventor : **Hansen, Robert A.
P.O. Box 1902
Elmira New York 14902 (US)**
Inventor : **Scott, Paul F.
19 Capitol Avenue
Hartford Connecticut 06106 (US)**
Inventor : **Vozenilek, Edward F.
511 Pinewood Circle
Elmira New York 14901 (US)**

(74) Representative : **Wetters, Basil David Peter et
al
Emhart Patents Department Lyn House 39 The
Parade
Oadby, Leicester LE2 5BB (GB)**

## Description

A bottle is formed from a gob of molten glass in an individual section glass container forming machine by first pressing or blowing the gob in a blank mould into a parison and then blowing the formed parison into a bottle in a finish mould. When glass is uniformly distributed during the formation of the bottle, wall thickness will be uniform, but when glass distribution is not uniform, thin spots can occur and these thin spots may result in bottle failure during filling or handling.

Historically, thin spots were identified by slicing a formed bottle and performing measurements along the cut wall to find locations which were unacceptably thin relative to the rest of the wall. When thin spots were found, the forming process was evaluated to find out why the glass was not being uniformly distributed.

U.S Specification 2,616,068 discloses a glass container inspection apparatus for measuring the thickness of the wall of a bottle by use of sensing means in the form of an electrode which is resiliently pressed against the bottle while the bottle is rotated about its axis, and detects changes in capacitance dependent on the thickness of the glass.

European Patent Application 300,616, applied for before the priority date of the present application but not published until after that priority date, discloses a glass container inspection apparatus for measuring the thickness of the wall of a bottle by use of an elongated electrode which is resiliently pressed against the bottle while the bottle is rolled along the electrode. Such an inspection machine is capable of operation at a higher speed with more accuracy than one in which the bottle is rotated in place, particularly because of problems caused by slight variations in the shape of the bottle.

The reader is also referred to DE-A-2 206 409 in which the difference between the maximum and the minimum wall thickness is calculated.

It is an object of the present invention to provide a glass container inspection apparatus which will not only reject a bottle whenever it identifies an unacceptable thin spot, but will also reject it if there is an unacceptable thick spot or an unacceptable non-uniform distribution of glass in the formed bottle.

The present invention provides a glass container inspection apparatus for measuring the thickness of a wall of a container by use of sensing means which produces a signal representative of the thickness of the wall of a container presented to it and comprising means for presenting a glass container to the sensing means so that its wall thickness may be sensed, characterized in that the apparatus comprises min-max ratio means responsive to signals produced by the sensing means for providing a ratio signal representative of the ratio of the minimum sensed wall thickness of the container to the maximum sensed wall thickness of the container and means responsive to said ratio signal for rejecting a glass container if said ratio is lower than a selected value.

Preferably in an apparatus according to the invention the sensing means comprises a capacitance sensing means. The capacitance sensing means is preferably in the form of an elongated sensor and the presenting means is arranged to roll the container along the sensor.

There now follows a description, to be read with reference to the accompanying drawings, of a preferred embodiment of a glass container inspection apparatus chosen to illustrate the invention by way of example.

In the accompanying drawings:

Figure 1 shows, diagrammatically, an inspection station of a glass container inspection apparatus;

Figure 2 is a logic diagram illustrating the operation of a controller of the apparatus to determine whether or not a container should be rejected;

Figure 3 shows, diagrammatically, mechanism for moving containers through the inspection station;

Figure 4 is a logic diagram illustrating steps to eliminate the effect of a side seam on inspection;

Figure 5 shows a container with a side seam and diagrammatically the effect of the logic illustrated in Figure 4;

Figure 6 is a schematic diagram illustrating the electronic circuit of the inspection apparatus.

The illustrative glass container inspection apparatus is for measuring the thickness of a wall of a container, for example a round glass bottle, by use of capacitance sensing means which produces a signal representative of the thickness of the wall of a bottle presented to it.

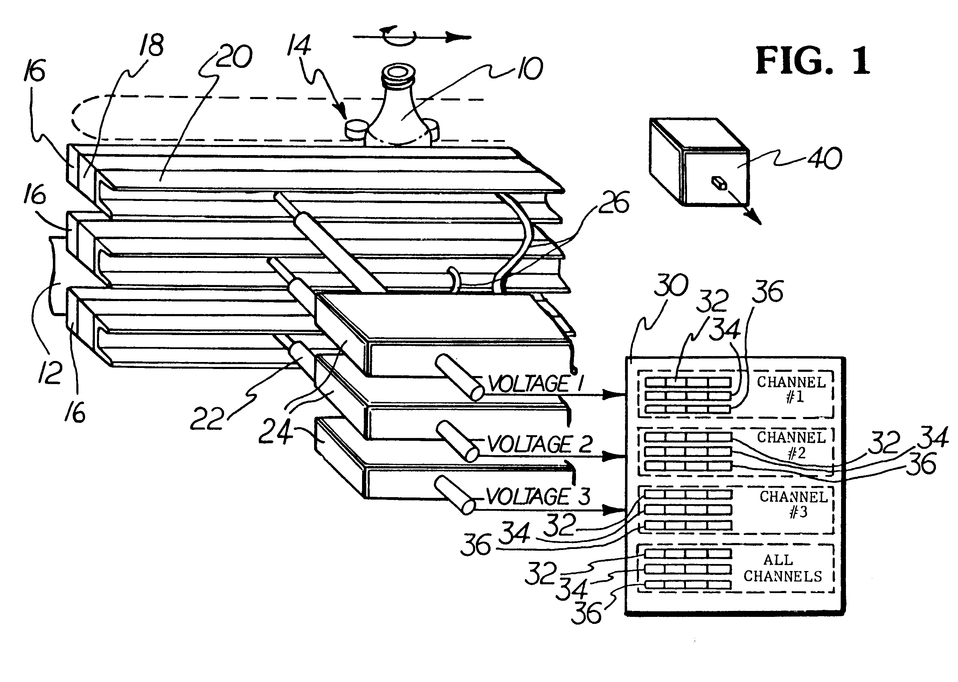

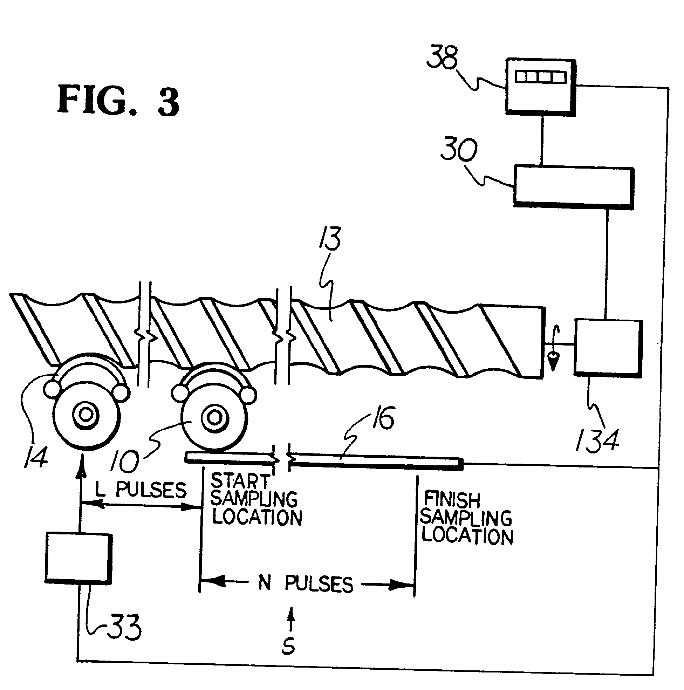

The illustrative apparatus comprises means for presenting a glass bottle to the sensing means so that its wall thickness may be sensed comprising bottle carriers 14 (Figures 1 and 3) which engage round glass bottles 10 supported on a plate 12. The carriers 14 are engaged by an elongated cam 13 which is rotated at a constant speed to carry the bottles in turn through an inspection station S. As each carrier 14 carries a bottle 10 through the inspection station S it rolls the bottle along a number (three as illustrated in Figure 1 for purposes of clarity, but four are normally used) of parallel horizontally extending, vertically spaced, elongated capacitance sensors 16 in the form of strips which are secured to resilient foam strips 18 mounted on suitable brackets 20. The brackets are connected by posts 22 to corresponding head oscillator assembly housings containing oscillator assemblies 24. Each oscillator assembly 24 receives a capacitance signal from its associated capacitance sensor 16 via a calibrated cable 26 and generates a continuous voltage signal which is supplied to a computer 30.

When the cam 13 carries a carrier 14 towards the inspection station S a start position of the carrier 14 is sensed by a suitable sensor 33. The rotational position of the cam 13 is monitored by an encoder 134 the encoder reading when the carrier 14 is at the start position is defined as the start pulse by the computer 30. As the cam continues to advance the carrier 14, a captured bottle 10 will be translated towards the right until the bottle engages the capacitance sensor 16 and reaches the beginning of the inspection station, as defined by a selected encoder pulse count (L). The sampling will then begin with a data sample being evaluated by the computer 30 at each subsequent count until the count reaches a selected number (N) which assures that the entire periphery of the bottle has been sampled (the Finish Sampling Location). For smaller bottles, a portion of this peripheral ring may be analysed twice. The operator inputs the diameter of the bottle via a hand held terminal or the like 38, and the computer sets the correct number (N) of pulses for the bottle.

The computer 30 of the illustrative apparatus comprises an array of settable thumb wheel switches 32, 34, 36 associated with each capacitance sensor, the switches 32 being adapted for setting a minimum wall thickness, the switches 34 a maximum wall thickness and the switches 36 a minimum/maximum wall thickness ratio.

Glass thickness measurements are made using each sensor 16 and cable 26 which have a capacitance about 50 pf without glass being sensed. The sensitivity of the sensor 16 to glass is about 0.002 pf of capacitance for each $2.54 \times 10^{-3}$ cm of glass and decreases as glass thickness increases.

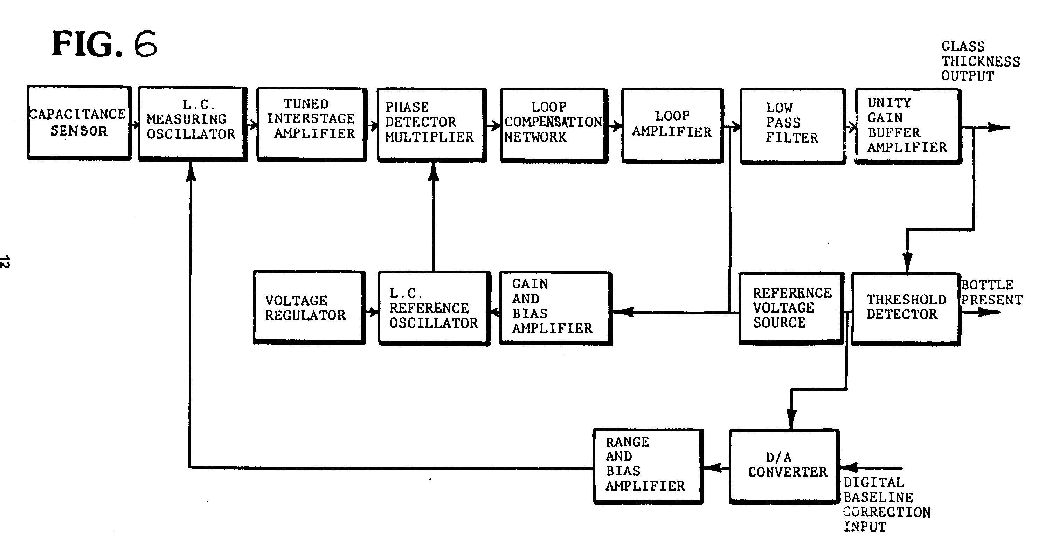

Each oscillator assembly 24 comprises [see Figure 6] a capacitance tuned Measuring Oscillator (a transformer coupled LC oscillator) formed by placing the sensor 16 in parallel with a ferrite pot core inductor which has an extra winding for feed-back. This measuring oscillator is tuned by the capacitance of the sensor and accordingly converts small changes in capacitance (a change in bottle thickness) to small changes in frequency. This output frequency is passed to a Tuned Interstage Amplifier which rejects signals that are outside the frequency range of interest. A capacitance tuned Reference Oscillator which is identical to the Measuring Oscillator is formed using an identical inductor and a stable capacitor that equals the no glass capacitance of the sensor and cable assembly.

To each oscillator is added some additional capacitance in the form of a varactor (a capacitor in series with a reversed biased tuning diode). The network values are chosen so that the diode can be biased by means of a biasing resistor over a range of voltages (from -3 to -10 volts). The value of the capacitance change due to the network and varactor is chosen to be approximately equal to the change in capacitance for the largest glass thickness expected.

Preferably the varactor bias of the Measuring Oscillator is set as a starting point approximately to the mid-point of its range and the bias of the varactor in the Reference Oscillator is set to its minimum point (-10 volts in the above example).

As will now be described, the computer 30 is arranged to be responsive to reject bottles if the signals produced by the sensors 16 indicate that the thickness of the wall of the container is, at any sensed point, greater than a selected maximum value or less than a selected minimum value or if the ratio of the signals representing the minimum sensed wall thickness to the maximum wall thickness is lower than a selected value.

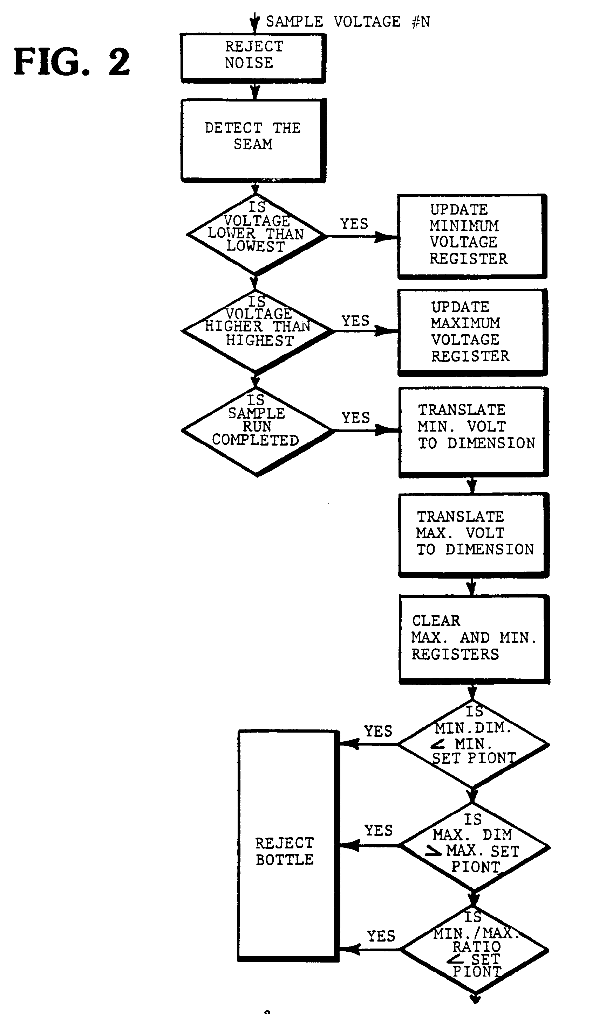

As can be seen from the logic diagram illustrated in Figure 2, in the computer 30 the voltage signal generated by each oscillator assembly is processed to Reject Noise (by averaging, for example). A Detect The Seam circuit determines that data in the vicinity of a seam is being generated and ignores this data which would produce a false thin spot reading, as will be described in more detail later. Two to three hundred readings or data samples are taken around the bottle at each sensor and then evaluated to identify the lowest and highest voltage around the bottle. These voltages are stored in suitable registers which are updated whenever a lower or higher voltage is sensed until readings have been taken completely around the bottle. A highest voltage and lowest voltage register can be provided for each sensor (channel) and a highest and lowest register can be provided for the data of all the sensors (channels). At this time, the voltage which represents the thinnest spot around the tested periphery (either for one or for all channels) and the voltage which represents the thickest spot around the tested periphery (either for one or for all channels) are converted via suitable A/D converters to dimensions (millimeter for example) and the registers are cleared for the next bottle. If the minimum dimension is less than the minimum set point, or if the maximum dimension is higher than the maximum set point or if the minimum to maximum ratio for these two dimensions is less than the minimum to maximum set point, the bottle will be rejected by a suitable reject mechanism 40, diagrammatically indicated in Figure 1.

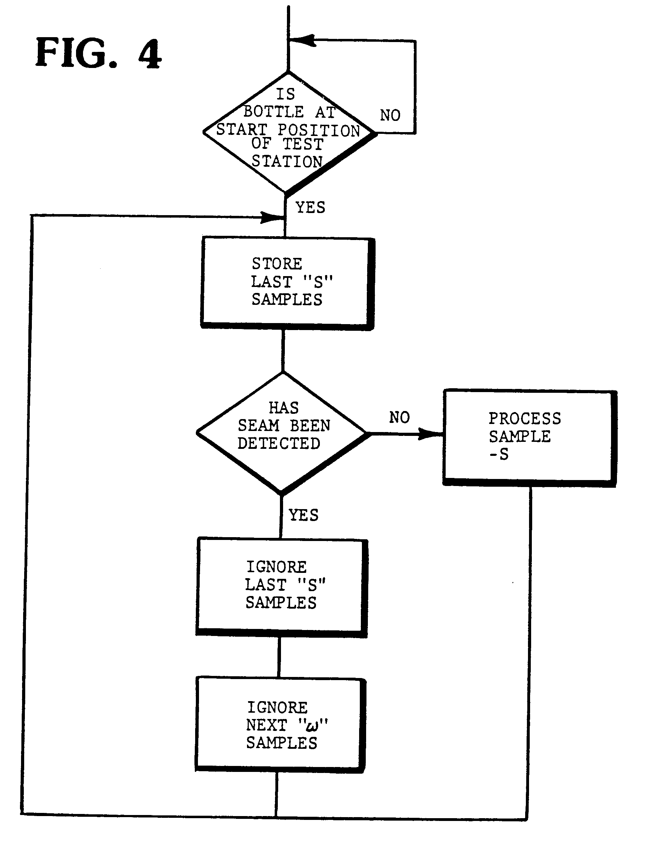

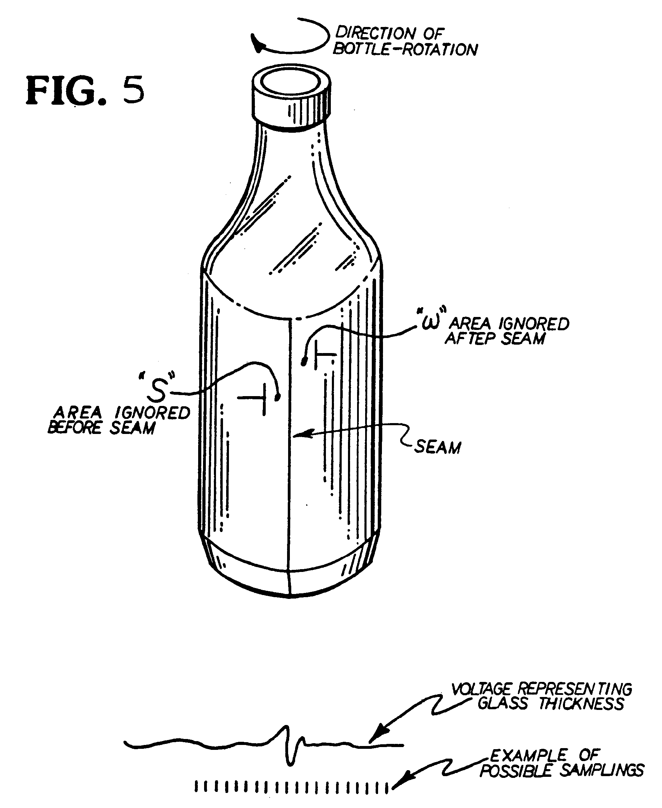

As can be seen from Figures 4 and 5, the last "S" (four, for example) data samples are stored in a Store Case "S" Sample and each time a new data sample is placed in storage, the oldest data sample will accordingly be evaluated at each pulse until the bottle wall seam has been detected by the computer 30 in a conventional manner; i.e. the computer 30 determines the rate of change or differential of the voltage representing glass thickness and whenever this differential exceeds a selected threshold, a seam has been detected. Thus the computer 30 includes a seam detector means. At this time, all the sample data in the Store Case "S" samples will be ignored as will future data samples for a "W" pulse count. "S" and "W" are settable, via a conventional computer input such as a keyboard, to cover a selected window during which seam data would normally be evaluated. Following the counting of "W" pulses, the sample data will again be evaluated each pulse until the Finish Sampling Location is reached.

Returning now to a more complete description of the capacitative wall thickness sensing circuit of Figure 6. A Phase Locked Loop is formed to adjust the voltage to exactly match the capacitance of the sensor and glass to the reference capacitance (the varactor) of the Reference Oscillator by coupling the two oscillator outputs with a Phase Detector Multiplier. The detected phase is fed to a Loop Compensation Network (a band width shaping filter) and Amplifier. Due to the gain of the Amplifier, a small error in phase will result in a substantial output voltage. The Loop is closed through a Gain and Bias Amplifier which is set as follows: When the amplifier output is at the desired minimum (0 volts in the illustrated case), the varactor is set to minimum capacitance (-10 volts to the varactor). The gain is set so that the desired maximum out of the amplifier (5 volts) sets the varactor to the maximum capacitance (-3 volts to the varactor).

The Phase Locked Loop is closed to force the Measuring Oscillator and the Reference Oscillator to operate at exactly the same frequencies. When no glass is sensed by the sensor, the frequencies are equal when the Reference Oscillator varactor is at minimum, so that the output of the Loop Amplifier is zero. As glass is sensed by the sensor, the output of the Loop Amplifier causes the varactor in the Reference Oscillator to change capacitance an amount exactly equal to the change in the Measuring Oscillator capacitance due to the glass wall thickness. The capacitance versus voltage characteristics of the varactor are known, and accordingly, this data can be inverted to form a voltage versus capacitance chart. Varactor capacitance varies slowly as a function of applied voltage. This chart is further shifted to a more convenient voltage scale by the action of the Gain and Bias Amplifier.

The varactor voltage versus capacitance curve is non-linear. A shift in the bias point of the varactor would cause an undesirable shift in scale factor within this scheme. Accordingly, when changes occur that shift the no glass value from the desired set point, a change in voltage is made to the varactor in the Measuring Oscillator. Since the predominant changes that occur are due to temperature, the control input can be referred to as the temperature compensating input. This preserves the scale of the phase locked output.

The glass thickness signal is obtained by passing the output of the Phase Locked Loop through a limiting Low Pass Filter and a Unity Gain Buffer Amplifier. From there, it goes to an A/D Converter and thence to the computer.

Samples that correspond to no glass are processed through a feedback algorithm that makes adjustments to a D/A converter. This keeps the base frequency of both Oscillators at the same frequency, i.e., when no glass is present, the frequency will remain fixed at a selected value even with temperature changes and stray capacitance.

The Measuring Oscillator is applied as the input to a phase lock Loop where the Reference Oscillator is used as the voltage controlled oscillator (VCO) because the phase locked loop tunes the VCO allowing no steady state frequency error between it and the input frequency, the capacitance of the reference capacitance must precisely match the capacitance of the sensor/bottle combination. The voltage across the reference provides a good representation of the bottle's wall thickness, limited in practice only by the match between the Measuring Reference Oscillators and by the temperature drift coefficient and sensitivity of the varactor.

Since there is a non-linear change in capacitance as a function of thickness over the range provided by glass containers, the computer comprises a linearizer which is arranged to adjust the voltage output of the measuring oscillator means so that the voltage is linearly related to the sensed wall thickness.

The linearizer uses basic non-linear regression techniques combined with a "good sense" model of the capacitance-wall thickness relationship. While regression techniques are well known, it is also well known that their success depends on a correct choice of model. If the model does not represent the data with sufficient accuracy, the results of the regression will not be accurate. Also, it is very difficult to postulate a "good" model. The relationship between the sensor capacitance and the wall thickness of the container is very non-linear. This situation cannot be improved by better sensor design because the required circumferential resolution of the measurement is of the same order of magnitude as the wall thickness. Thus, the electric fields in the container must fall-off substantially over the range of container wall thicknesses, creating a proportionately non-linear capacitance function. The relationship between wall thickness and capacitance cannot be obtained analytically as it is a three-dimensional solution of Maxwell's equations for highly non-idealized geometries. Computer numerical solutions are possible, and while these provide insight into sensor design, they are too cumbersome and time consuming to use in a wall thickness instrument to determine the thickness value corresponding to a measured capacitance. However, as the relationship between thickness and capacitance must be linear for small thickness and as the thickness increases, the capacitance will approach some "infinite thickness" value. Assuming that the "cross-over" point between these two solutions occurs at a thickness value on the order of half the probe spacing a model can be proposed which has been shown empirically to represent wall thickness data very well. This model is as follows:

$$C(T) = A \times T / (1 + B \times T)$$

where:
C is the measured capacitance, T is the wall thickness, A is a coefficient describing the small thickness, linear relationship and B is a coefficient describing the large thickness, non-linear relationship. The "infinite thickness" capacitance is A/B and cross-over wall thickness is 1/B. This model is also easy to employ in a wall thickness device because "pseudo" linear regression techniques can be used to calculate A and B from two or more known pairs (for example determined experimentally) of C and T. The model can also be used to express T in terms of C, i.e.

$$T = \frac{C}{A - BC}$$

## Claims

1. A glass container inspection apparatus for measuring the thickness of a wall of a container by use of sensing means (16) which produces a signal representative of the thickness of the wall of a container (10) presented to it and comprising means (13,14) for presenting a glass container to the sensing means (16) so that its wall thickness may be sensed, characterized in that the apparatus comprises min-max ratio means responsive to signals produced by the sensing means for providing a ratio signal representative of the ratio of the minimum sensed wall thickness of the container to the maximum sensed wall thickness of the container and means responsive to said ratio signal for rejecting a glass container if said ratio is lower than a selected value.

2. Apparatus according to claim 1, characterized in that it comprises means for altering the selected value of the min-max ratio.

3. Apparatus according to one of claims 1 and 2, characterized in that the signal representative of the thickness is a voltage signal and the min-max ratio means comprises;
   means for sampling said voltage at a selected number of sample locations around the wall of the glass container,
   first means for determining the smallest sampled voltage which is representative of the thinnest sampled location of the glass container,
   second means for determining the highest sampled voltage which is representative of the thickest sampled location of the glass container, and

means for providing a ratio signal proportional to the ratio of said smallest sampled voltage to said highest sampled voltage.

4. Apparatus according to any one of the preceding claims, characterized in that the sensing means comprises a plurality of sensors (16) and that the min-max ratio means comprises means for providing a ratio signal for each of the sensors.

5. Apparatus according to one of claims 1, 2 and 3, characterized in that the sensing means comprises a plurality of sensors (16) and that the min-max ratio means comprises means for providing a ratio signal representative of the ratio of the minimum thickness sensed by any of the sensors to the maximum thickness sensed by any of the sensors.

6. Apparatus according to any one of the preceding claims wherein the sensing means comprises a capacitance sensing means.

7. Apparatus according to claim 6, wherein the capacitance sensing means comprises an elongated sensor and the presenting means is arranged to roll the container along the sensor.

## Patentansprüche

1. Glasbehälter-Prüfapparat zum Messen der Dicke einer Wand eines Behälters unter Verwendung einer Fühleinrichtung (16), welche ein die Dicke der Wand eines ihr dargebotenen Behälters (10) darstellendes Signal erzeugt, mit einer Einrichtung (13,14), um einen Glasbehälter der Fühleinrichtung darzubieten, so daß seine Wanddicke gefühlt werden kann, dadurch gekennzeichnet, daß der Prüfapparat eine Minimum-Maximum-Verhältnis-Einrichtung, welche auf von der Fühleinrichtung erzeugte Signale anspricht, um ein Verhältnissignal zu schaffen, welches das Verhältnis der minimalen gefühlten Wanddicke des Behälters zur maximalen gefühlten Wanddicke des Behälters darstellt, und eine auf das Verhältnissignal ansprechende Einrichtung zum Abweisen eines Glasbehälters umfaßt, wenn das Verhältnis geringer als ein gewählter Wert ist.

2. Prüfapparat nach Anspruch 1, dadurch gekennzeichnet, daß er eine Einrichtung zum Ändern des gewählten Wertes des Minimum-Maximum-Verhältnisses umfaßt.

3. Prüfapparat nach einem der Ansprüche 1 und 2, dadurch gekennzeichnet, daß das die Dicke darstellende Signal ein Spannungssignal ist und daß die Minimum-Maximum-Verhältnis-Einrichtung eine Einrichtung zum Abtasten der Spannung an einer ausgewählten Anzahl von Prüfstellen um die Wand des Glasbehälters herum, eine erste Einrichtung zum Bestimmen der niedrigsten abgetasteten Spannung welche die dünnste Prüfstelle des Glabehälters darstellt, eine zweite Einrichtung zum Bestimmen der höchsten abgetasteten Spannung, welche die dickste Prüfstelle des Glasbehälters darstellt, und eine Einrichtung zum Schaffen eines Verhältnissignales proportional dem Verhältnis der niedrigsten Prüfspannung zur höchsten Prüfspannung umfaßt.

4. Prüfapparat nach einem der vorhergehenden Ansprüche, dadurch gekennzeichnet, daß die Fühleinrichtung eine Vielzahl von Sensoren (16) umfaßt und daß die Minimum-Maximum-Verhältnis-Einrichtung eine Einrichtung zum Schaffen eines Verhältnissignales für jeden der Sensoren einschließt.

5. Prüfapparat nach einem der Ansprüche 1, 2 oder 3, dadurch gekennzeichnet, daß die Fühleinrichtung eine Vielzahl von Sensoren (16) umfaßt und daß die Minimum-Maximum-Verhälnis-Einrichtung eine Einrichtung zum Schaffen eines Verhältnissignales einschließt, welches das Verhältnis der minimalen Dicke, die von einem der Sensoren erfaßt ist, zu der maximalen Dicke ist, welche von einem der Sensoren erfaßt ist.

6. Prüfapparat nach einem der vorhergehenden Ansprüche, dadurch gekennzeichnet, daß die Fühleinrichtung eine Kapazitätfühleinrichtung ist.

7. Prüfapparat nach Anspruch 6, dadurch gekennzeichnet, daß die Kapazitätsfühleinrichtung einen länglichen Sensor umfaßt und daß die Darbieteinrichtung so angeordnet ist, daß sie den Behälter längs des Sensors rollt.

**Revendications**

1. Appareil d'inspection de récipients en verre destiné à mesurer l'épaisseur d'une paroi d'un récipient en utilisant des moyens capteurs (16) qui produisent un signal représentatif de l'épaisseur de la paroi d'un récipient (10) présenté à cet appareil, et comprenant des moyens (13, 14) destinés à présenter un récipient en verre aux moyens capteurs (16) de manière que son épaisseur de paroi puisse être captée, caractérisé en ce que l'appareil comprend des moyens de rapport mini-maxi qui répondent à des signaux produits par les moyens capteurs en émettant un signal de rapport représentatif du rapport de l'épaisseur minimale captée de paroi du récipient à l'épaisseur maximale captée de paroi du récipient, et des moyens qui répondent à ce signal de rapport en rejetant un récipient en verre si ledit rapport est inférieur à une valeur choisie.

2. Appareil selon la revendication 1, caractérisé en ce qu'il comprend des moyens permettant d'altérer la valeur choisie du rapport mini-maxi.

3. Appareil selon une des revendications 1 et 2, caractérisé en ce que le signal représentatif de l'épaisseur est un signal de tension et les moyens de rapport mini-maxi comprennent :
   - des moyens servant à échantillonner cette tension en un nombre choisi d'emplacements d'échantillonnage sur le tour de la paroi du récipient en verre ;
   - des premiers moyens servant à déterminer la plus petite tension échantillonnée qui est représentative de l'emplacement échantillonné le plus mince du récipient en verre ;
   - des deuxièmes moyens servant à déterminer la plus forte tension échantillonnée qui est représentative de l'emplacement échantillonné le plus épais du récipient en verre ; et
   - des moyens servant à émettre un signal de rapport proportionnel au rapport liant cette plus petite tension échantillonnée à cette plus forte tension échantillonnée.

4. Appareil selon une quelconque des revendications précédentes, caractérisé en ce que les moyens capteurs comprennent des capteurs (16) et en ce que les moyens de rapport mini-maxi comprennent des moyens servant à émettre un signal de rapport pour chacun des capteurs.

5. Appareil selon une quelconque des revendications 1, 2 et 3, caractérisé en ce que les moyens capteurs comprennent plusieurs capteurs (16) et en ce que les moyens de rapport mini-maxi comprennent des moyens servant à émettre un signal de rapport représentatif du rapport de l'épaisseur minimale captée par un quelconque des capteurs à l'épaisseur maximale captée par l'un quelconque des capteurs.

6. Appareil selon une quelconque des revendications précédentes, dans lequel les moyens capteurs comprennent des moyens capteurs de capacité électrique.

7. Appareil selon la revendication 6, dans lequel les moyens capteurs de capacité comprennent un capteur de forme allongée et les moyens de présentation sont agencés pour faire rouler le récipient le long du capteur.

# FIG. 1

# FIG. 2

SAMPLE VOLTAGE #N

```
REJECT
NOISE
```

```
DETECT THE
SEAM
```

IS VOLTAGE LOWER THAN LOWEST — YES →
```
UPDATE
MINIMUM
VOLTAGE
REGISTER
```

IS VOLTAGE HIGHER THAN HIGHEST — YES →
```
UPDATE
MAXIMUM
VOLTAGE
REGISTER
```

IS SAMPLE RUN COMPLETED — YES →
```
TRANSLATE
MIN. VOLT
TO DIMENSION
```

```
TRANSLATE
MAX. VOLT
TO DIMENSION
```

```
CLEAR
MAX. AND MIN.
REGISTERS
```

IS MIN.DIM. ≤ MIN. SET PIONT — YES →

IS MAX. DIM ≥ MAX. SET PIONT — YES →

IS MIN./MAX. RATIO ≤ SET PIONT — YES →

```
REJECT
BOTTLE
```

8

# FIG. 3

38

30

13

134

14

10

16

L PULSES

START
SAMPLING
LOCATION

FINISH
SAMPLING
LOCATION

N PULSES

33

S

# FIG. 4

```
                    │
                    │◄─────────────┐
                    ▼              │
                 ╱╲               │
                ╱  ╲              │
               ╱ IS  ╲            │
              ╱ BOTTLE AT╲   NO   │
             ╱START POSITION╲─────┘
             ╲  OF TEST    ╱
              ╲  STATION  ╱
               ╲        ╱
                ╲      ╱
                 ╲    ╱
                  ╲  ╱
                   ╲╱
                    │ YES
   ┌────────────────┤
   │                ▼
   │         ┌──────────────┐
   │         │    STORE     │
   │         │  LAST "S"    │
   │         │   SAMPLES    │
   │         └──────────────┘
   │                │
   │                ▼
   │              ╱╲
   │             ╱  ╲
   │            ╱ HAS ╲      NO      ┌──────────────┐
   │           ╱SEAM BEEN╲──────────►│   PROCESS    │
   │           ╲DETECTED ╱           │   SAMPLE     │
   │            ╲      ╱             │    - S        │
   │             ╲    ╱              └──────────────┘
   │              ╲  ╱                      │
   │               ╲╱                       │
   │                │ YES                    │
   │                ▼                        │
   │         ┌──────────────┐                │
   │         │   IGNORE     │                │
   │         │  LAST "S"    │                │
   │         │   SAMPLES    │                │
   │         └──────────────┘                │
   │                │                        │
   │                ▼                        │
   │         ┌──────────────┐                │
   │         │   IGNORE     │                │
   │         │  NEXT "ω"    │                │
   │         │   SAMPLES    │                │
   │         └──────────────┘                │
   │                │                        │
   └────────────────┴────────────────────────┘
```

**FIG.** 5

DIRECTION OF
BOTTLE-ROTATION

"ω" AREA IGNORED
AFTEP SEAM

"S"
AREA IGNORED
BEFORE SEAM

SEAM

VOLTAGE REPRESENTING
GLASS THICKNESS

EXAMPLE OF
POSSIBLE SAMPLINGS

# FIG. 6

GLASS
THICKNESS
OUTPUT

BOTTLE
PRESENT

DIGITAL
BASELINE
CORRECTION
INPUT

Blocks: CAPACITANCE SENSOR → L.C. MEASURING OSCILLATOR → TUNED INTERSTAGE AMPLIFIER → PHASE DETECTOR MULTIPLIER → LOOP COMPENSATION NETWORK → LOOP AMPLIFIER → LOW PASS FILTER → UNITY GAIN BUFFER AMPLIFIER

VOLTAGE REGULATOR, L.C. REFERENCE OSCILLATOR, GAIN AND BIAS AMPLIFIER, REFERENCE VOLTAGE SOURCE, THRESHOLD DETECTOR

RANGE AND BIAS AMPLIFIER, D/A CONVERTER

EP 0 363 113 B1